# EUROPEAN PATENT APPLICATION

(11) **EP 2 566 051 A1**
(43) Date of publication of application: **06.03.2013**
(21) Application number: 12175188.7
(22) Date of filing: 05.07.2012
(51) Int. Cl.: H03H 9/10, H03H 9/05

(54) **Piezoelectric vibration device and oscillator**

(30) Priority: 01.09.2011 JP 2011190575
(71) Applicant: Seiko Instruments Inc., Chiba-shi, Chiba (JP)
(72) Inventor: Yoshida, Yoshifumi, Chiba-shi, Chiba (JP)
(74) Representative: Miller Sturt Kenyon

(57) **Abstract**

A piezoelectric vibration device (1) is provided that can reduce the stress and strain that transmit through a base substrate. The piezoelectric vibration device includes a piezoelectric vibrating reed (4) that oscillates in an AT mode, and that includes excitation electrodes (5,6) respectively formed on the front and back surfaces of the reed. One of the excitation electrodes is connected to the base substrate via a metal bump (15b) on a center line passing across the shorter sides of the piezoelectric vibrating reed and in the vicinity of one of the shorter sides of the piezoelectric vibrating reed. The other excitation electrode is connected to the base substrate via a metal bump (15a) on the same side as the above shorter side, and in the vicinity of a portion where the shorter side of the piezoelectric vibrating reed crosses one of the longer sides of the piezoelectric vibrating reed.

## Description

The present invention relates to piezoelectric vibration devices mounting electronic elements.

Electronic devices using a surface-mounted small package have been commonly used for portable information terminals such as cell phones that have become pervasive over the last years. For example, devices such as a vibrator, an MEMS, a gyrosensor, and an acceleration sensor are structured to include an electronic element housed inside a package of a hollow cavity structure. In one known type of a package having a hollow cavity structure, for example, a base substrate and a cover substrate are bonded to each other for air-tight sealing. With the recent trend for miniaturization, the flip chip bonding technique is used as a method of bonding an electronic device to the base substrate (see, for example, JP-A-2010-103868).

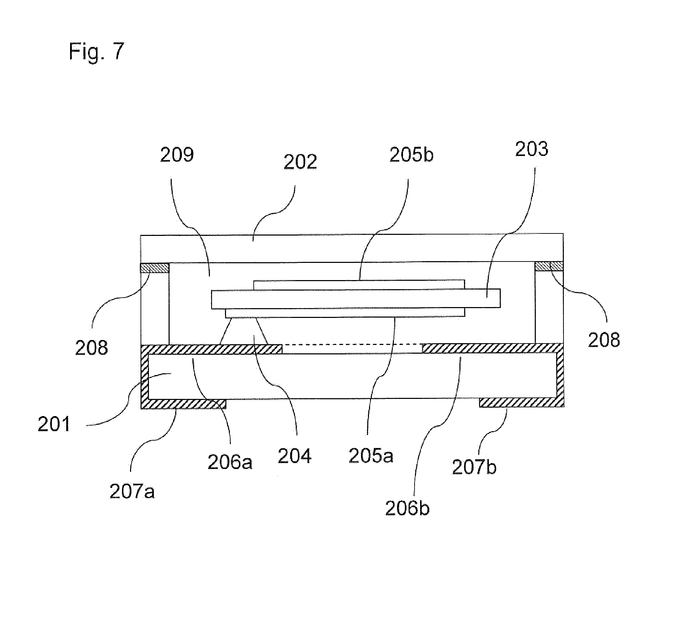

A piezoelectric vibrator is briefly described below in which a piezoelectric vibrating reed is fixed onto a base substrate with metal bumps. As illustrated in FIG. 7, a piezoelectric vibrator 200 is configured to include a piezoelectric vibrating reed 203, a depressed base substrate 201, and a cover substrate 202 bonded to the base substrate 201 at a bond portion 208.

The piezoelectric vibrating reed 203 is formed of piezoelectric material such as quartz. Excitation electrodes 205a and 205b are patterned on both sides of the piezoelectric vibrating reed 203 to vibrate the piezoelectric vibrating reed 203. The piezoelectric vibrating reed 203 is bonded via the excitation electrodes 205a and 205b and metal bumps 204 to routing electrodes 207a and 207b formed on the base substrate 201.

The base substrate 201 has a depression, and a cavity 209 is created upon sealing the depression with the cover substrate 202. The piezoelectric vibrating reed 203 is housed inside the cavity 209.

The base substrate 201 is configured as a ceramic substrate, and external electrodes 207a and 207b are formed on the bottom surface and over the side surfaces of the base substrate 201. The external electrode 207a is electrically connected to the excitation electrode 205a of the piezoelectric vibrating reed 203 via the routing electrode 206a, whereas the external electrode 207b is electrically connected to the excitation electrode 205b of the piezoelectric vibrating reed 203 via the routing electrode 206b.

The cover substrate 202 is configured as a ceramic substrate or a metal substrate, and is bonded to the base substrate 201 on a bonding face 208 by seam welding or Au-Sn welding to seal the cavity 209.

### SUMMARY OF THE INVENTION

However, as illustrated in FIG. 7, because the piezoelectric vibrating reed 203 is firmly fixed to the base substrate 201 with the metal bumps 204, the strain or stress of the base substrate 201 is directly exerted on the piezoelectric vibrating reed 203.

Further, in the piezoelectric vibrating reed of a common AT-cut quartz vibrator, the piezoelectric vibrating reed is held at two locations at the both end portions on the shorter side on one surface of the piezoelectric vibrating reed, in order to stably hold the piezoelectric vibrating reed. In this configuration, the distance between the metal bumps is about the same as the length on the shorter side of the piezoelectric vibrating reed, and the distance between the metal bumps is long. The stress due to the difference between the thermal expansion coefficients of the base substrate and the piezoelectric vibrating reed is determined by the distance between the metal bumps. Such stress is problematic, because it is exerted on the piezoelectric vibrating reed, and greatly changes the vibration characteristics of the piezoelectric vibrating reed.

Accordingly, there is a need for a piezoelectric vibration device that can reduce the stress and strain that transmit through the base substrate, even when the piezoelectric vibrating reed is held using metal bumps.

According to an embodiment of the present invention, there is provided a piezoelectric vibration device that includes:
a base substrate;
a cover substrate facing and bonded to the base substrate; and
a piezoelectric vibrating reed housed in a cavity formed between the base substrate and the cover substrate, and bump bonded to a top surface of the base substrate,
wherein the piezoelectric vibrating reed is a piezoelectric vibrating reed that oscillates in an AT mode, and that includes excitation electrodes respectively formed on the front and back surfaces of the reed, and mount electrodes electrically connected to the excitation electrodes, respectively,
one of the mount electrodes being electrically connected to the base substrate via a first metal bump on a center line passing across the shorter sides of the piezoelectric vibrating reed and in the vicinity of one of the shorter sides of the piezoelectric vibrating reed, and
the other mount electrode being electrically connected to the base substrate via a second metal bump in the vicinity of a portion where the one of the shorter sides of the piezoelectric vibrating reed crosses one of the longer sides of the piezoelectric vibrating reed.

With the embodiment of the present invention, the adverse effect of the stress and strain of the base substrate on the piezoelectric vibrating reed can be minimized. Specifically, because the distance between the metal bumps is shorter than in the method of related art used to hold the piezoelectric vibrating reed, the stress and strain exerted on the piezoelectric vibrator from the cover substrate or the base substrate do not fluctuate as much, and thus the characteristics of the piezoelectric vibrating reed can be stabilized. It is also possible to stably hold the piezoelectric vibrating reed.

In the piezoelectric vibration device, one of the mount electrodes may be further connected to the base substrate via a third metal bump. The third metal bump may be disposed in the vicinity of the one of the shorter sides of the piezoelectric vibrating reed and on the other longer side opposite the one of the longer sides of the piezoelectric vibrating reed. The first metal bump, the second metal bump, and the third metal bump may be aligned in a straight line.

In this way, the piezoelectric vibrating reed can be stably held. Further, because of the first metal bump disposed between the second metal bump and the third metal bump aligned in a straight line, the stress due to the distance between the second metal bump and the third metal bump hardly becomes a factor. Because of the short distance between the metal bumps, there will be no stress due to the difference between the thermal expansion coefficients of the base substrate and the piezoelectric vibrating reed. In this way, the piezoelectric vibrating reed can be held even more stably, and changes in the vibration characteristics of the piezoelectric vibrating reed can be prevented.

In the piezoelectric vibration device, the second metal bump and the third metal bump may be equidistant from the first metal bump disposed between the second metal bump and the third metal bump.

The present invention can minimize the adverse effect of the stress and strain of the base substrate on the piezoelectric vibrating reed. Specifically, because the distance between the metal bumps is shorter than in the method of related art used to hold the piezoelectric vibrating reed, the stress and strain exerted on the piezoelectric vibrator from the cover substrate or the base substrate do not fluctuate as much, and the characteristics of the piezoelectric vibrating reed can be stabilized. It is also possible to stably hold the piezoelectric vibrating reed.

Embodiments of the present invention will now be described by way of further example only and with reference to the accompanying drawings, in which:
FIG. 1 is a schematic view representing a longitudinal section of a piezoelectric vibration device according to a First Embodiment of the present invention.
FIG. 2 is a schematic view of a top surface of the piezoelectric vibration device according to a First Embodiment of the present invention.
FIG. 3 is an exploded perspective view of the piezoelectric vibration device according to a First Embodiment of the present invention.
FIG. 4 is a schematic view representing a longitudinal section of a piezoelectric vibration device according to a Second Embodiment of the present invention.
FIG. 5 is a schematic view of a top surface of a piezoelectric vibration device according to a Third Embodiment of the present invention.
FIG. 6 is a schematic view of a top surface of an oscillator according to a Fourth Embodiment of the present invention.
FIG. 7 is a schematic view representing a longitudinal section of a piezoelectric vibration device of related art.

### Piezoelectric Vibration Device

### First Embodiment

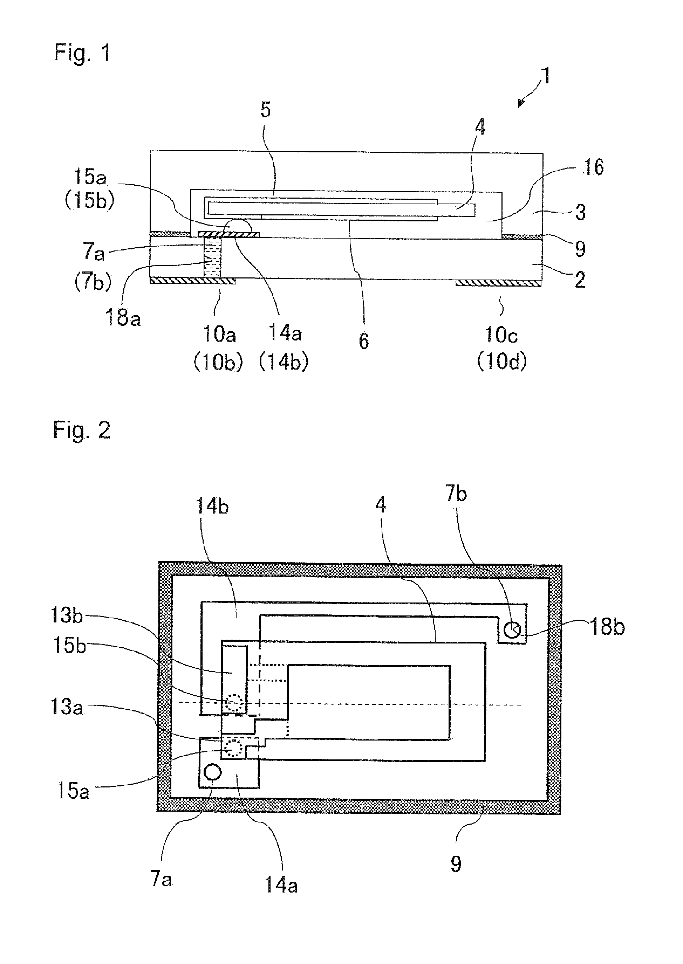

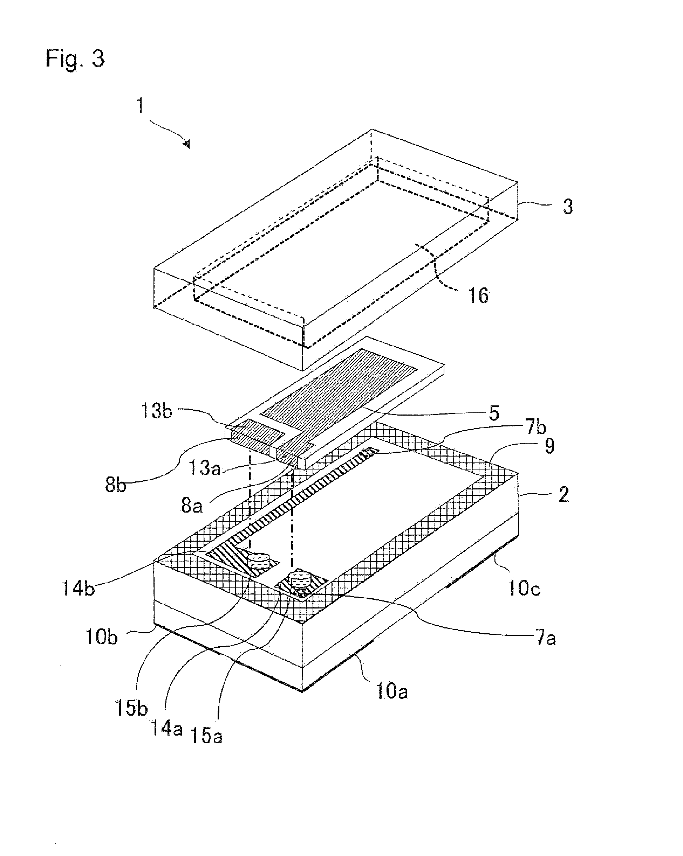

FIG. 1 is a cross sectional view of a piezoelectric vibration device 1 according to First Embodiment taken along the longer side through a through electrode 7a, as viewed from the side of a piezoelectric vibrating reed 4. FIG. 2 is a schematic view showing a top surface of the piezoelectric vibration device 1. FIG. 3 is an exploded perspective view. A cover substrate 3 is omitted in FIG. 2.

The piezoelectric vibration device 1 of the present embodiment is a box-shaped laminate of a base substrate 2 and a cover substrate 3 facing and bonded to the base substrate 2. Further, the piezoelectric vibration device 1 is a surface-mounted piezoelectric vibration device that includes a piezoelectric vibrating reed 4 housed inside a cavity 16 formed between the base substrate 2 and the cover substrate 3. The piezoelectric vibrating reed 4 is held to the base substrate 2 in a cantilever fashion on one of the shorter sides of the piezoelectric vibrating reed 4.

As illustrated in FIG. 3, the piezoelectric vibrating reed 4 is an AT-cut type vibrating reed formed of a quartz piezoelectric material, and vibrates in response to an applied predetermined voltage.

The piezoelectric vibrating reed 4 includes a pair of electrodes comprising a second excitation electrode 5 and a first excitation electrode 6 disposed on the opposing back and front surfaces of the plate quartz, and mount electrodes 13a and 13b electrically connected to the second excitation electrode 5 and the first excitation electrode 6, respectively. The mount electrodes 13a and 13b are electrically connected to the second excitation electrode 5 and the first excitation electrode 6, respectively, via plate quartz side electrodes 8a and 8b.

The second excitation electrode 5, the first excitation electrode 6, the mount electrodes 13a and 13b, and the side electrodes 8a and 8b are formed as conductive film coatings using materials, for example, such as chromium (Cr), nickel (Ni), gold (Au), aluminum (Al), and titanium (Ti), or as laminated films of some of these conductive films.

The piezoelectric vibrating reed 4 configured as above is bump bonded to the top surface of the base substrate 2 via a second metal bump 15a and a first metal bump 15b formed of material such as gold. Specifically, the second metal bump 15a and the first metal bump 15b are formed on the routing electrodes 14a and 14b (described later), respectively, patterned on the top surface of the base substrate 2. The mount electrodes 13a and 13b are in contact with the second metal bump 15a and the first metal bump 15b, respectively. The piezoelectric vibrating reed 4 is bump bonded to the base substrate 2 in this state. The piezoelectric vibrating reed 4 is thus supported above the top surface of the base substrate 2 with a clearance equivalent of the thickness of the second metal bump 15a and the first metal bump 15b, with the mount electrodes 13a and 13b being electrically connected to the routing electrodes 14a and 14b, respectively.

The cover substrate 3 is configured from an insulator, a semiconductor, or a metal. Further, the cover substrate 3 has a rectangular depression formed on the surface bonded to the base substrate 2, in order to contain the piezoelectric vibrating reed 4. Upon mating the substrates 2 and 3, the depression becomes the cavity 16 that houses the piezoelectric vibrating reed 4. The cover substrate 3 is bonded to the base substrate 2 via a bonding film 9 with the depression 16 facing the base substrate 2. Bonding may be made by using various methods, for example, such as anodic bonding.

The base substrate 2 is configured from an insulator, a semiconductor, or a metal. Further, the base substrate 2 is plate-like in shape, and sized to be mated with the cover substrate 3.

A pair of through holes 18a and 18b is formed through the base substrate 2 in the base substrate 2 (preferably at diagonally opposite corners). The through holes 18a and 18b are formed within the cavity 16. Specifically, the through hole 18a is formed on the side of the mount electrodes 13a and 13b mounting the piezoelectric vibrating reed 4, whereas the through hole 18b is formed on the opposite side of the mount electrodes 13a and 13b of the piezoelectric vibrating reed 4. Though the through holes 18a and 18b are described as being formed straight through the base substrate 2 in the present embodiment, the through holes 18a and 18b are not limited to this configuration, and may be formed, for example, in a tapered fashion with a gradually decreasing diameter toward the lower surface of the base substrate 2, provided that the through holes 18a and 18b are formed through the base substrate 2.

A pair of through electrodes 7a and 7b is formed that plugs the through holes 18a and 18b, respectively in the pair of through holes 18a and 18b. The through electrodes 7a and 7b completely close the through holes 18a and 18b to maintain the cavity 16 air tight, and serve to bring the routing electrodes 14a and 14b in communication with external electrodes 10a and 10d (described later). The gap between the through holes 18a and 18b and the through electrodes 7a and 7b is completely closed by melting the base substrate 2.

The routing electrodes 14a and 14b are patterned so as to electrically connect the through electrode 7a to the mount electrode 13a of the piezoelectric vibrating reed 4, and the through electrode 7b to the mount electrode 13b of the piezoelectric vibrating reed 4. Specifically, the routing electrode 14a is formed on the through electrode 7a on the side of the mount electrodes 13a and 13b of the piezoelectric vibrating reed 4. The routing electrode 14b is formed on the through electrode 7b by being routed along the piezoelectric vibrating reed 4 from the position adjacent to the routing electrode 14a to the side opposite the through electrode 7a on the base substrate 2.

The second metal bump 15a and the first metal bump 15b are formed on the routing electrodes 14a and 14b, respectively, and the piezoelectric vibrating reed 4 is mounted by using the second metal bump 15a and the first metal bump 15b. In this way, the mount electrode 13a of the piezoelectric vibrating reed 4 is in communication with the through electrode 7a via the routing electrode 14a, and the mount electrode 13b is in communication with the through electrode 7b via the routing electrode 14b.

As illustrated in FIG. 1, external electrodes 10a and 10d are formed on the lower surface of the base substrate 2 (preferably at diagonally opposite corners) by being electrically connected to the through electrodes 7a and 7b, respectively. Specifically, the external electrode 10a is electrically connected to the second excitation electrode 5 of the piezoelectric vibrating reed 4 via the through electrode 7a and the routing electrode 14a. The external electrode 10d is electrically connected to the first excitation electrode 6 of the piezoelectric vibrating reed 4 via the through electrode 7b and the routing electrode 14b.

The piezoelectric vibration device 1 configured as above is activated by applying a predetermined drive voltage to the external electrodes 10a and 10d formed on the base substrate 2. In response, a current flows into the excitation electrode consisting of the second excitation electrode 5 and the first excitation electrode 6 of the piezoelectric vibrating reed 4, and causes vibration at a predetermined frequency. The vibration can then be used as, for example, a timing source of control signals, or a reference signal source.

When the base substrate 2 and the piezoelectric vibrating reed 4 are bonded with a strong bump bond, a large stress is exerted on areas around the mount electrodes 13a and 13b of the piezoelectric vibrating reed 4 because of a large thermal expansion difference between the base substrate 2 and the piezoelectric vibrating reed 4. Under such stress, the frequency and temperature characteristics of the piezoelectric vibrating reed 4 change greatly. This is particularly problematic in the AT-cut vibrating reed used in this embodiment, because the frequency stability and the stability of temperature characteristics are important in this type of vibrator.

In the piezoelectric vibrator of related art, a ceramic substrate is used as the base substrate 2. The thermal expansion coefficient of a ceramic substrate is about 7 x 10⁻⁶/°C, smaller than that of the AT-cut vibrating reed. Thus, a large stress is exerted on the piezoelectric vibrating reed 4 bump bonded to the base substrate 2, and the frequency and the temperature characteristics are adversely affected.

There is a method in which a conductive adhesive is used for the bonding of a ceramic base substrate and a piezoelectric vibrating reed to softly bond the base substrate and the piezoelectric vibrating reed. It should be mentioned here that miniaturization of the piezoelectric vibration device reduces the size of the mount electrodes 13a and 13b of the piezoelectric vibrating reed 4, and thus makes the bonding region of the conductive adhesive smaller. However, because the conductive adhesive has fluidity and increases the bonding area, reducing the bonding region (= the size of the mount electrodes 13a and 13b) involves difficulties. It might be possible to increase the size of the mount electrodes 13a and 13b to ensure the bonding region. However, this reduces the size of the excitation electrode 5 and 6, and makes the vibrating region of the piezoelectric vibrating reed 4 smaller. This is problematic, because it leads to characteristics deterioration.

In the present embodiment, the second metal bump 15a and the first metal bump 15b used to bond the piezoelectric vibrating reed 4 to the base substrate 2 are disposed at positions different from those adopted in the related art. Specifically, the first metal bump 15b is disposed on the center line passing across the shorter sides of the piezoelectric vibrating reed 4, in the vicinity of one of the shorter sides of the piezoelectric vibrating reed 4. The second metal bump 15a is disposed in the vicinity of the same shorter side where the first metal bump 15b is disposed, in the vicinity of the portion (preferably corner) where one of the shorter sides and one of the longer sides of the piezoelectric vibrating reed 4 cross. In other words, the mount electrode 13b of the piezoelectric vibrating reed 4 is electrically connected to the base substrate 2 via the first metal bump 15b on the center line passing across the shorter sides of the piezoelectric vibrating reed 4 and in the vicinity of one of the shorter sides of the piezoelectric vibrating reed 4, whereas the mount electrode 13a is electrically connected to the base substrate 2 via the second metal bump 15a in the vicinity of the portion where one of the shorter sides of the piezoelectric vibrating reed 4 crosses one of the longer sides of the piezoelectric vibrating reed 4.

Because the piezoelectric vibrating reed 4 and the base substrate 2 are bonded at these locations, the distance between the second metal bump 15a and the first metal bump 15b can be reduced, and the thermal expansion difference between the base substrate 2 and the piezoelectric vibrating reed 4 becomes less of a factor. Accordingly, there will be less change in characteristics such as frequency and temperature characteristics than in the related art. Further, because the second metal bump 15b is on the center line passing across the shorter sides of the piezoelectric vibrating reed 4, the second metal bump 15b can hold the piezoelectric vibrating reed 4 with sufficient stability. It should be noted that when the both metal bumps are disposed on one of the longer sides, the piezoelectric vibrating reed 4 cannot be held as stably as in the present embodiment.

Further, the use of the bump bond can solve the problems of using a conductive adhesive. Specifically, characteristic changes can be prevented in the present embodiment, because no large bonding region is needed.

Further, because the conductive adhesive takes time to solidify, the piezoelectric vibrating reed 4 is held throughout the assembly procedures. In other case, the piezoelectric vibrating reed 4 needs to be bonded by being tilted in advance, so that the piezoelectric vibrating reed 4 becomes parallel to the base substrate 2 on its own weight as the conductive adhesive solidifies. These steps can be omitted by the bump bonding performed in the present embodiment.

Further, because the piezoelectric vibrating reed 4 is supported on the bump bond above the base substrate 2, the vibration gap necessary for the vibration can already be provided. Thus, unlike the cover substrate 3, the base substrate 2 does not need the depression for the cavity 16, and can be formed as a plate-like substrate. Without the depression (cavity) 16, the thickness of the base substrate 2 can be reduced as much as possible. The thickness of the piezoelectric vibration device 1 can thus be reduced according to the present embodiment.

### Second Embodiment

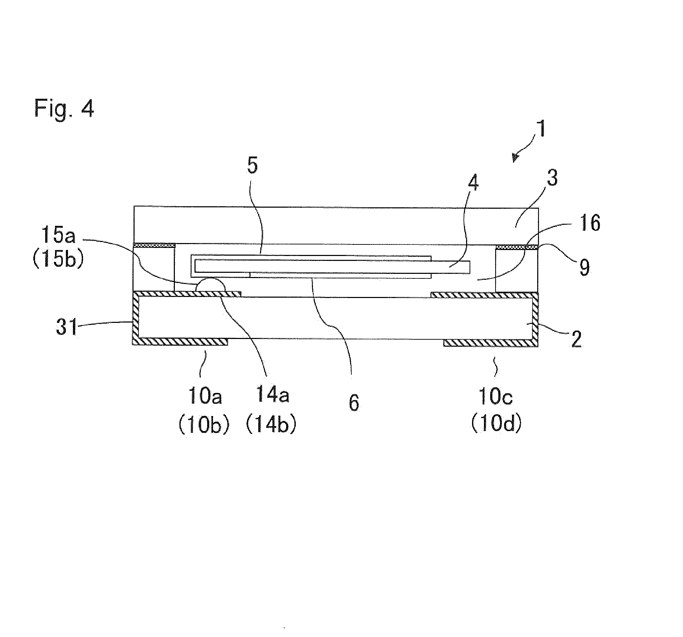

FIG. 4 is a cross sectional view of a piezoelectric vibration device 1 according to Second Embodiment of the present invention taken along the longer side through a routing electrode 14a, as viewed from the side of a piezoelectric vibrating reed 4. Second Embodiment differs from First Embodiment in that the base substrate 2 is provided as a "depressed" substrate, and the cover substrate 3 as a plate-like substrate. The other configuration is substantially the same as that described in First Embodiment. In the following, descriptions will be made with primary focus on these differences, using the same reference numerals for the same members and for members having the same functions.

The cover substrate 3 is a plate-like substrate configured from an insulator, a semiconductor, or a metal. The base substrate 2 has a rectangular depression in which the piezoelectric vibrating reed 4 is contained. Upon mating the substrates 2 and 3, the depression becomes the cavity 16 that houses the piezoelectric vibrating reed 4. The base substrate 2 is bonded to the cover substrate 3 via a bonding film 9 with the depression facing the cover substrate 3.

The base substrate 2 is a depressed plate-like substrate configured from an insulator, a semiconductor, or a metal, and sized to be mated with the cover substrate 3. The routing electrodes 14a and 14b and the external terminals 10a and 10d are connected to each other, respectively, using side-surface external electrodes 31 and 32, without using the through holes or through electrodes. Specifically, the routing electrodes 14a and 14b formed on the base substrate 2 extend to the outer periphery of the piezoelectric vibration device 1, and are connected to the side-surface external electrodes 31 and 32. The external electrodes 10a and 10d formed on the surface of the base substrate 2 opposite the surface with the routing electrodes 14a and 14b extend to the outer periphery of the piezoelectric vibration device 1, and are connected to the side-surface external electrodes 31 and 32. In this way, the same effects described in First Embodiment can be obtained.

### Third Embodiment

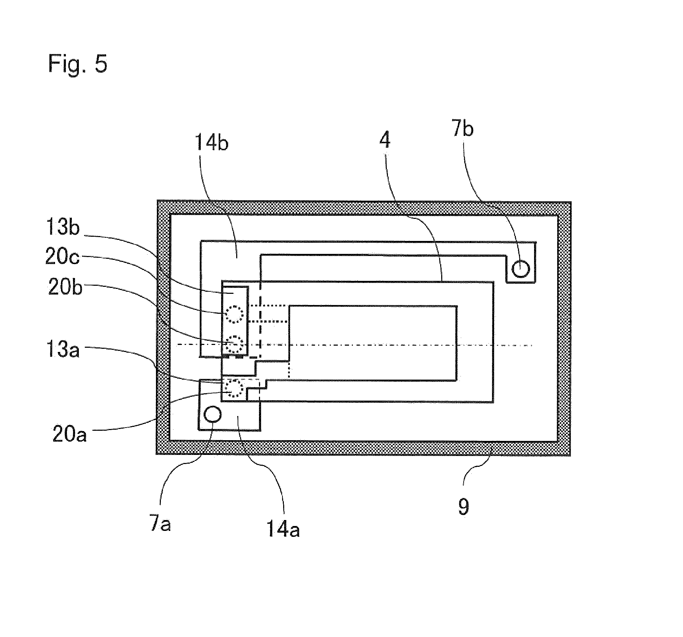

FIG. 5 is a schematic view showing a top surface of a piezoelectric vibration device 1 according to Third Embodiment of the present invention. The cover substrate 3 is omitted in FIG. 5. Third Embodiment differs from First Embodiment in that the piezoelectric vibrating reed 4 is held with bumps at three locations. The other configuration is substantially the same as that described in First Embodiment. In the following, descriptions will be made with primary focus on these differences, using the same reference numerals for the same members and for members having the same functions.

In the present embodiment, as illustrated in FIG. 5, the piezoelectric vibrating reed 4 is bonded to the base substrate 2 with three bumps. Specifically, a first metal bump 20b and a second metal bump 20a are disposed in the configuration described in First Embodiment. Additionally, in the present embodiment, the mount electrode 13b electrically connected to the first metal bump 20b is also connected to the base substrate 2 via a third metal bump 20c. The third metal bump 20c is disposed in the vicinity of one of the shorter sides of the piezoelectric vibrating reed 4 and on one of the longer sides of the piezoelectric vibrating reed 4 opposite the other longer side where the second metal bump 20a is disposed. The first metal bump 20b, the second metal bump 20a, and the third metal bump 20c are aligned in a straight line.

In this way, the piezoelectric vibrating reed 4 can be more stably held than in First Embodiment. Further, because of the first metal bump 20b disposed between the second metal bump 20a and the third metal bump 20c aligned in a straight line, the stress due to the distance between the second metal bump 20a and the third metal bump 20c hardly becomes a factor. Because the distance between the metal bumps is shorter than that of the related art, there will be no stress due to the difference between the thermal expansion coefficients of the base substrate 2 and the piezoelectric vibrating reed 4, as in First Embodiment.

Thus, the piezoelectric vibrating reed 4 can be held even more stably, and changes in the vibration characteristics of the piezoelectric vibrating reed 4 can be prevented.

Preferably, the distance between the first metal bump 20b and the second and third metal bumps 20a and 20c should be as short as possible. However, considering the bump size and the accuracy of mount positions, it is desirable that the distance be 80 to 300 µm.

For bonding, the three metal bumps may be disposed in a triangular layout. However, this causes larger characteristic changes, because all the stress due to the thermal expansion difference between these three points will be exerted on the piezoelectric vibrating reed 4. It is therefore desirable that the three metal bumps be disposed in a straight line.

The second metal bump 20a and the third metal bump 20c may be equidistant from the first metal bump 20b. In this way, the piezoelectric vibrating reed 4 can be held more horizontally, and stability can be improved.

The distance between the third metal bump 20c and the first metal bump 20b may be shorter than the distance between the second metal bump 20a and the first metal bump 20b. The distance between the third metal bump 20c and the first metal bump 20b may be appropriately changed depending on such factors as the size of the base substrate 2 and the piezoelectric vibrating reed 4.

With the metal bumps disposed at three locations and in a layout more toward the center line passing across the shorter sides of the piezoelectric vibrating reed 4, the adverse effect on the stability and the vibration characteristics can be minimized.

The mount electrode 13b need not be electrically connected to both the first, central metal bump 20b and the third metal bump 20c.

### Oscillator

### Fourth Embodiment

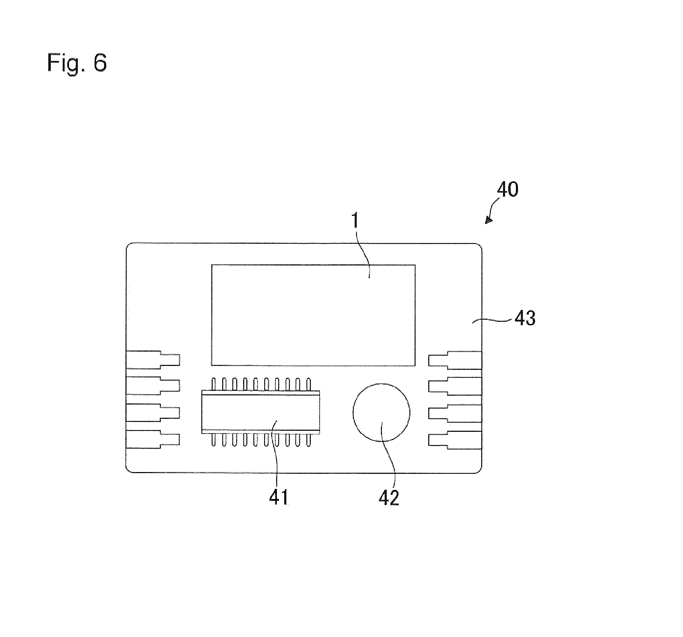

FIG. 6 is a schematic view showing a top surface of an oscillator 40 according to Fourth Embodiment of the present invention. In the oscillator 40, the piezoelectric vibration device 1 using the piezoelectric vibrating reed 4 of one of the foregoing embodiments is installed. As illustrated in FIG. 6, the oscillator 40 includes a substrate 43. The piezoelectric vibration device 1, along with an integrated circuit 41 and an electronic component 42, is mounted on the substrate 43. The piezoelectric vibration device 1 generates a signal of a certain frequency based on a drive signal applied to the electrode terminals 10a and 10d. The integrated circuit 41 and the electronic component 42 process the signal of a certain frequency supplied from the piezoelectric vibration device 1, and generate a reference signal such as a clock signal. Because the piezoelectric vibration device 1 of the embodiment of the present invention can be formed in small size with high reliability, the overall size of the oscillator 40 can be made compact.

The foregoing description has been given by way of example only and it will be appreciated by a person skilled in the art that modifications can be made without departing from the scope of the present invention.

## Claims

1. A piezoelectric vibration device (1), comprising:
a base substrate (2);
a cover substrate (3) facing and bonded to the base substrate; and
a piezoelectric vibrating reed (4) housed in a cavity (16) formed between the base substrate and the cover substrate, and bump bonded to a top surface of the base substrate,
wherein the piezoelectric vibrating reed is a piezoelectric vibrating reed that oscillates in an AT mode, and that includes excitation electrodes (5, 6) respectively formed on the front and back surfaces of the reed, and mount electrodes (13a, 13b) electrically connected to the excitation electrodes, respectively,
one of the mount electrodes (13b) being electrically connected to the base substrate (2) via a first metal bump (15b) on a center line passing across the shorter sides of the piezoelectric vibrating reed and in the vicinity of one of the shorter sides of the piezoelectric vibrating reed, and
the other mount electrode (13a) being electrically connected to the base substrate (2) via a second metal bump (15a) in the vicinity of a portion where said one of the shorter sides of the piezoelectric vibrating reed crosses one of the longer sides of the piezoelectric vibrating reed.

2. The piezoelectric vibration device according to claim 1, wherein one of the mount electrodes (13b) is further connected to the base substrate (2) via a third metal bump (15c),
wherein the third metal bump is disposed in the vicinity of said one of the shorter sides of the piezoelectric vibrating reed and of another longer side opposite said one of the longer sides of the piezoelectric vibrating reed, and
wherein the first metal bump (15b), the second metal bump (15a), and the third metal bump (15c) are aligned in a straight line.

3. The piezoelectric vibration device according to claim 2, wherein the second metal bump (15a) and the third metal bump (15c) are equidistant from the first metal bump (15b) disposed between the second metal bump and the third metal bump.

4. An oscillator (40) comprising:
the piezoelectric vibration device (1) of any one of claims 1 to 3; and
a drive circuit (41) arranged to supply a drive signal to the piezoelectric vibration device.
